# EUROPEAN PATENT SPECIFICATION

(11) **EP 2 929 607 B1**
(45) Date of publication and mention of the grant of the patent: **16.09.2020**
(21) Application number: 13815256.6
(22) Date of filing: 05.12.2013
(51) Int. Cl.: H02H 3/30, H02H 7/26, H02H 1/00, G01R 31/52, G01R 19/165

(54) **POWER DISTRIBUTION SYSTEM WITH TESTING OF TRANSMISSION LINE**
ENERGIEVERTEILUNGSSYSTEM MIT PRÜFUNG DER ÜBERTRAGUNGSLEITUNG
SYSTÈME DE DISTRIBUTION DE PUISSANCE AVEC TEST DE LA LIGNE DE DISTRIBUTION

(30) Priority: 07.12.2012 US 201213707842
(43) Date of publication of application: 14.10.2015
(73) Proprietor: Voltserver Inc., Charlestown, Rhode Island 02813 (US)
(72) Inventor: EAVES, Stephen, Charleston, Rhode Island 02813 (US)
(74) Representative: Smith, Jeremy Robert
(86) International application number: PCT/US2013/073375
(87) International publication number: WO 2014/089329

(56) References cited:
- EP-A2- 1 970 717
- US-A1- 2009 204 268

## Description

### Field of Invention

This invention relates to power distribution system safety protection devices-for example, power distribution systems with electronic monitoring to detect and disconnect power in the event of an electrical fault or safety hazard, particularly where an individual has come in contact with exposed conductors. This invention is applicable to general power distribution, or more specifically to electric vehicle charging, telecommunications or alternative energy power systems.

### Background

In a typical power distribution application, power from a central source is distributed through a number of branch circuits to a load device. The branch circuits are equipped with protection devices, such as circuit breakers or fuses. During an electrical fault, such as a short circuit, the protection devices are designed to detect an abnormally high level of current and to disconnect or interrupt the source from the load before causing damage or fire to the distribution system.

The introduction of the Ground Fault Interrupter (GFI) added electrocution protection to the distribution system by detecting an imbalance between phase currents in a particular branch circuit, indicating that current is flowing through an alternate ground path and possibly in the process of electrocuting an individual.

However, there are significant shortcomings in traditional distribution protection methods. For example, a fire could still occur from a loose connection. In this case, the resistance of a live connection increases and heats up to the point of igniting surrounding materials. This heat build-up could occur at electrical currents well below the trip point of the branch circuit protection devices. In the case of GFI protection, the GFI circuit can only protect an individual that comes in contact with both a line conductor and a ground point, such as would be the case if an individual touched a live electric conductor with one hand and a sink faucet with the other hand. However, if the individual manages to touch both a live conductor and a return path (such as across the "hot" and neutral conductors of a home outlet) the GFI would not activate and the person would receive a shock.

Another important concept is a metric used to relate the lethality of an electric shock to the duration and magnitude of a current pulse flowing through the body. One metric used to describe this relationship by electrophysiologists is known as the chronaxie; a concept similar to what engineers refer to as the system time constant. Electrophysiologists determine a nerve's chronaxie by finding the minimal amount of electrical current that triggers a nerve cell using a long pulse. In successive tests, the pulse is shortened. A briefer pulse of the same current is less likely to trigger the nerve. The chronaxie is defined as the minimum stimulus length to trigger a cell at twice the current determined from that first very long pulse. A pulse length below the chronaxie for a given current will not trigger a nerve cell. The invention of this disclosure can take advantage of the chronoxie principle to keep the magnitude and duration of the energy packet to be safely below the level that could cause electrocution.

Electrocution is the induction of a cardiac arrest by electrical shock due to ventricular fibrillation (VF). VF is the disruption of the normal rhythms of the heart. Death can occur when beating of the heart becomes erratic, and blood flow becomes minimal or stops completely. McDaniel, et al., in the paper "Cardiac Safety of Neuromuscular Incapacitating Defensive Devices", Pacing and Clinical Electrophysiology, Volume 28, Number 1, January 2005, provides a conservative reference for estimating the minimum electrical charge necessary to induce VF under conditions similar to those of the disclosed invention. The study was performed to investigate the safety aspects of electrical neuromuscular incapacitation devices commonly used by law enforcement agencies for incapacitating violent suspects. McDaniel measured the response of a series of pigs to multiple, brief (150 µs) electrical pulses applied to the thorax of the animals. In these tests, a threshold charge of 720 µC could induce VF in a 30kg animal. The barbed darts were placed on the surface of the animal in close proximity to the heart and penetrated enough to bypass the normal insulating barrier of the skin. This results in a body resistance as low as 400 Ohms. In comparison, the U.S. Occupational Safety and Health Agency (OSHA) describes the resistance of wet human skin to be approximately 1000 Ohms.

By carefully monitoring the transfer of electrical energy contained sent by a source to a load device, it can be determined if some other mechanism, such as an external short circuit, or person receiving a shock, has affected the transfer of energy. The transfer can then be interrupted to protect the equipment or personnel. If the period of a current pulse is below the muscle chronaxie, human skeletal or heart muscles will be much less affected by the pulse. The avoidance of a building or equipment fire is also critical, but the level of energy to cause a fire is normally much less than that which would cause cardiac arrest. The disclosed invention can monitor and control the transfer of energy in small increments, and can thus offer additional safety over what can be provided even by the combination of a circuit breaker and a ground fault interrupter.

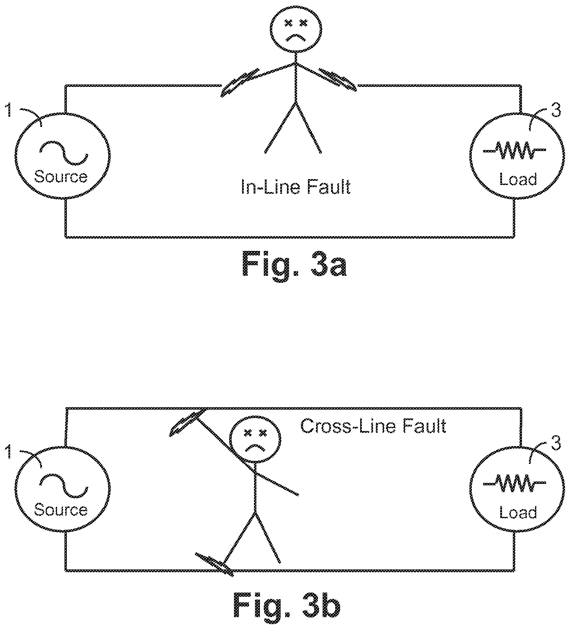

There are two primary fault modes to be detected. The first mode is an in-line or series fault where an abnormal resistance is put in series with the path between the source and load, as is illustrated by the individual being shocked in FIG. 3a. The second fault mode is a cross-line or parallel fault as is illustrated in FIG. 3b. The in-line fault can be detected by an abnormal drop in voltage between the source and load points for a given electrical current. In the disclosed invention, the cross line fault can be detected by a reduction in impedance between the output conductors after they have been isolated from both the source and the load by electronic switching.

US 2009/0204268 A1 discloses a power distribution system that regulates the transfer of energy from a source to a load.

EP 1970717 A2 discloses a method involving separating a supply terminal for a short time interval from the load and at the load terminal observing the voltage curve.

### Summary

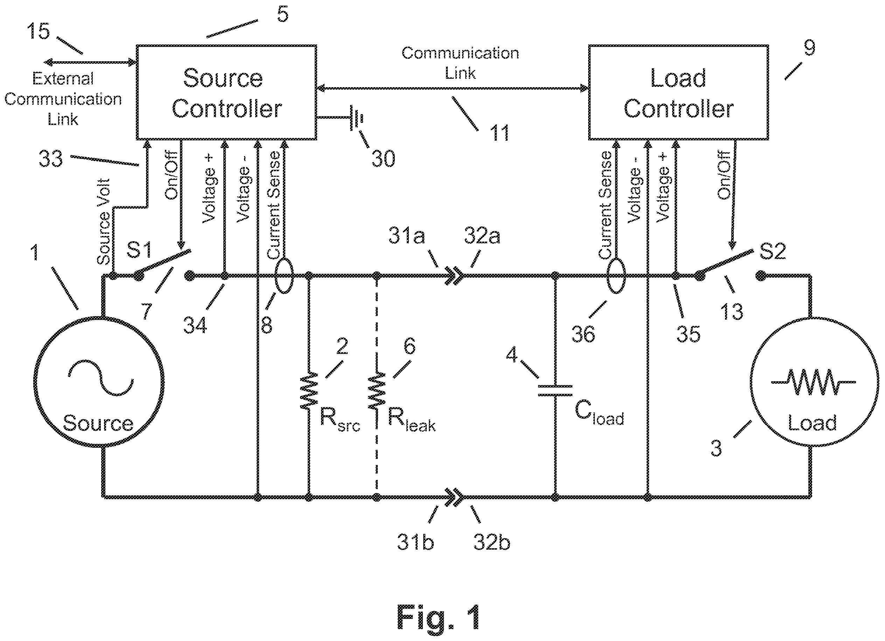

A block diagram of an embodiment of the power distribution system is shown in FIG. 1. The power distribution system regulates the transfer of energy from a source **1** to a load **3.** Periodically, the source controller **5** opens the S1 disconnect switch **7** for a predetermined time period, known as the "sample period". Capacitor C_{load} **4** is electrically connected to the load terminals. The capacitor stores the voltage present on load terminals **32a, 32b** that existed just prior to the moment that S1 is opened; references to "voltage" here and in the claims also include current and/or other parameters that vary with voltage. The resistance between the source terminals is represented by R_{src} **2.** In a particular embodiment, R_{src} has a value between 10 thousand to 10 million Ohms.

During normal conditions, when S1 is opened, the voltage across capacitor C_{load} will decay as it discharges through R_{src} and into the load. Switch S2 **13** isolates C_{load} from the load circuit. S2 can take any of a number of forms, ranging from a non-controllable diode to a controllable bi-directional solid state switch, as will be discussed later in the detailed description section. At this point, the source terminals **31a**, **31b** and load terminals **32a, 32b** are electrically isolated from source **5** and load **9.** The only discharge path for the capacitance represented by C_{load} should be the source terminal resistance R_{src}. However, during a cross-line fault, depicted in FIG. 3b, the resistance of a foreign object, such as a human body or conductive element, is introduced and is represented by Rₗₑₐₖ**6**. The parallel combination of R_{src} and Rₗₑₐₖ will increase the voltage decay rate of C_{load} significantly. The voltage on C_{load} just prior to S1 being opened is measured by the source controller **5.** At the end of the predetermined sample period, just prior to where S1 is commanded back to a closed (conducting) state, the voltage of C_{load} is measured again and compared to the measurement that was made just prior to the beginning of the sample period.

If the voltage across C_{load} has decayed either too quickly or too slowly, a fault is registered and S1 will not be returned to a closed position. If S2 is a controllable version, it will also remain in an open (non-conducting) state. A high decay rate indicates a cross-line fault, as depicted in FIG. 3b. A low decay rate indicates an in-line fault, as depicted in FIG. 3a. In a distribution system where DC power is being transferred, the difference in the voltage decay rate on C_{load} during normal operation and when there is a cross-line fault is depicted in FIG. 4. In a distribution system where AC power is being transferred, the difference in voltage decay rate on C_{load} during normal operation and when there is a cross-line fault is depicted in FIG. 5.

If there are no fault conditions, S1 is again commanded to a closed (conducting) state and S2, if a controllable version is commanded to a conducting state. Energy is then transferred between the source and load until the next sample period. The conducting period between sample periods is referred to as the "transfer period".

An additional check for the in-line fault depicted in FIG. 3a is where the source and load controllers acquire their respective terminal voltages at sensing points **34,35** of FIG. 1 during an energy transfer period. In embodiments incorporating advanced monitoring options, communication link **11** will be implemented and the source controller will obtain the load terminal voltage through the communication link. The source controller then calculates the voltage difference between the two measurements. The source controller also acquires the electrical current passing through the source terminals using a current sensor **8.** The source controller can now calculate the line resistance between the source and load terminals using Ohms law, or the relationship: Resistance = Voltage/Current. The calculated line resistance is compared to a predetermined maximum and minimum value. If the maximum is exceeded, S1 and S2 (if a controllable version) are immediately opened and an in-line fault is registered. A line resistance that is lower than expected is also an indication of a hardware failure.

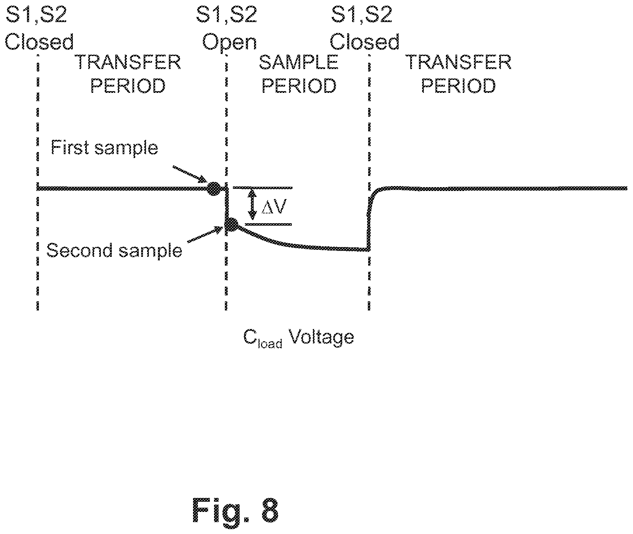

An alternative method to measure in in-line resistance without a communications link to the load is where the source controller measures the source terminal voltage at sensing point **34** and the electrical current passing through the source terminals using a current sensor **8.** The voltage and current samples are made nearly simultaneously during the same energy transfer period. Disconnect switch S1 is then opened and the source controller takes another voltage sample at sensing point **34.** The sample is taken immediately after S1 is opened. The difference in magnitude between the first and second voltage samples is proportional to the line resistance. As depicted in FIG. 8, the voltage drop between the first and second voltage samples is independent of the normal, slower decay in voltage that occurs for the remainder of the sample period because the second voltage sample is taken before the voltage on C_{load} has time to decay significantly.

### Brief Description of the Drawings

**FIG. 1** is a block diagram of an embodiment of the safe power distribution system.

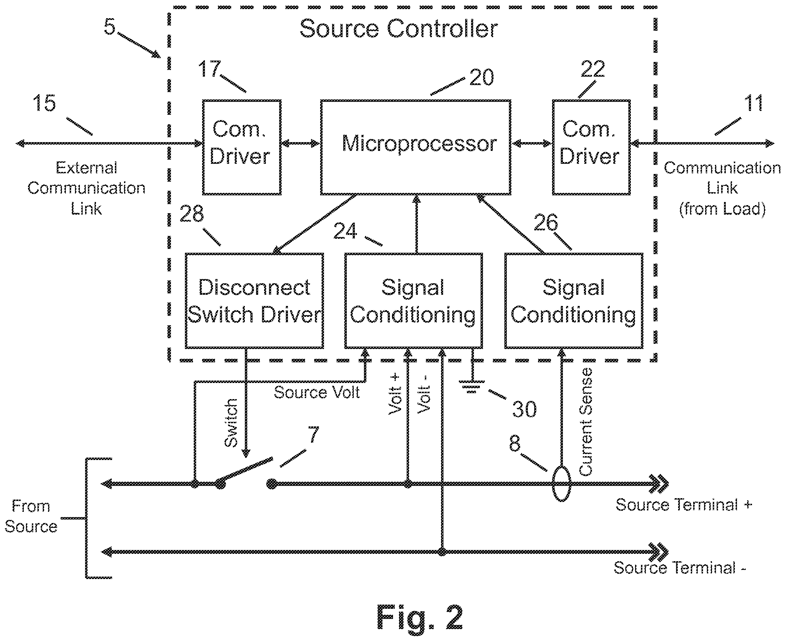

**FIG. 2** is a more detailed block diagram of an embodiment of the source controller.
**FIG. 3a** is a diagram depicting an in-line, or series shock hazard.
**FIG. 3b** is a diagram depicting a cross-line of parallel shock hazard.

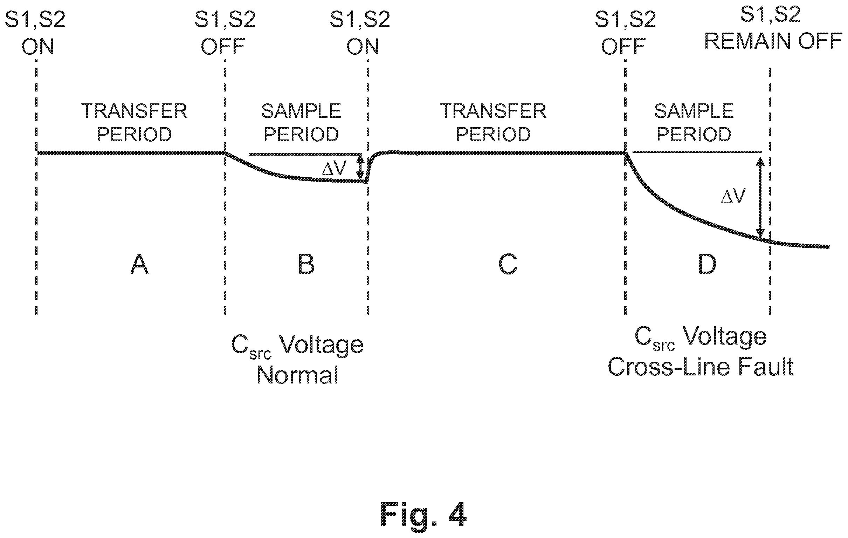

**FIG. 4** is a diagram showing the voltage on the power distribution system output conductors with a direct current (DC) source.

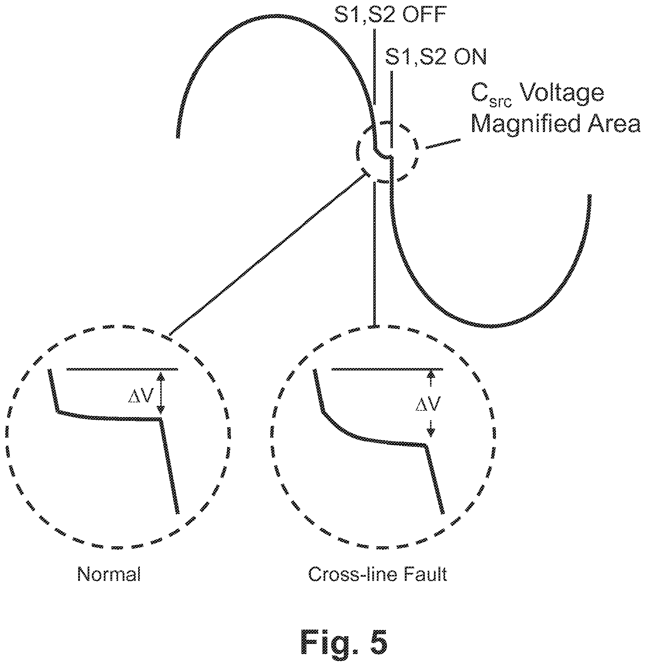

**FIG. 5** is a diagram showing the voltage on the power distribution system output conductors with an alternating current (AC) source

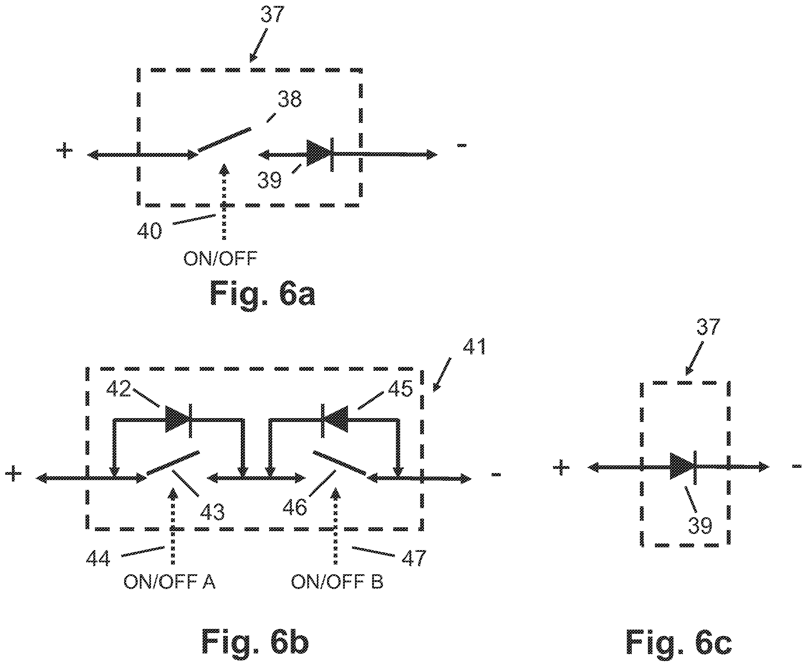

**FIG. 6a** is a diagram of a DC disconnect switch constructed using a uni-directional switch arrangement with a blocking diode.
**FIG. 6b** is a diagram of an AC disconnect switch constructed using a bi-directional switch arrangement.
**FIG. 6c** is a diagram of a uni-directional DC disconnect switch constructed with only a diode.

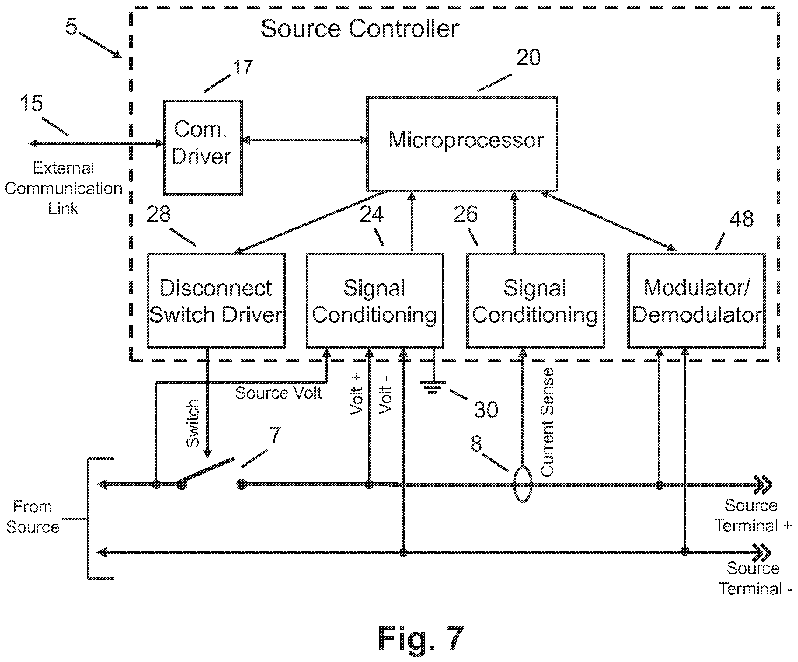

**FIG. 7** is a diagram of an alternate source controller configuration that includes a modulator/demodulator for communications over power lines.
**FIG. 8** is a diagram of the source voltage waveform depicting voltage sampling for an in-line resistance calculation.

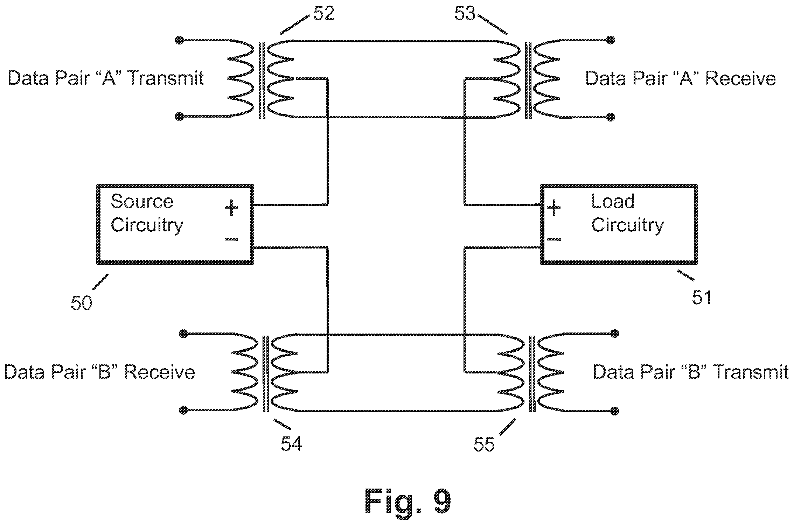

**FIG. 9** is a diagram of using center-tapped isolation transformers to combine user data and power on common twisted pair cabling.

### Detailed Description

The foregoing and other features and advantages of various aspects of the invention(s) will be apparent from the following, more-particular description of various concepts and specific embodiments within the broader bounds of the invention(s). Various aspects of the subject matter introduced above and discussed in greater detail below may be implemented in any of numerous ways, as the subject matter is not limited to any particular manner of implementation. Examples of specific implementations and applications are provided primarily for illustrative purposes.

Unless otherwise defined, used or characterized herein, terms that are used herein (including technical and scientific terms) are to be interpreted as having a meaning that is consistent with their accepted meaning in the context of the relevant art and are not to be interpreted in an idealized or overly formal sense unless expressly so defined herein.

The terminology used herein is for the purpose of describing particular embodiments and is not intended to be limiting of exemplary embodiments. As used herein, singular forms, such as "a" and "an," are intended to include the plural forms as well, unless the context indicates otherwise. Additionally, the terms, "includes," "including," "comprises" and "comprising," specify the presence of the stated elements or steps but do not preclude the presence or addition of one or more other elements or steps.

There are a number of industry standard methods for constructing the S1 and S2 disconnect switches **7, 13** of FIG. 1. In one embodiment, the construction of S1 and S2 is determined based on whether the system is distributing DC or AC power and whether the load-side switch is controllable or a simple diode. For DC power distribution, where the load controller is able to control the action of S2, a DC disconnect switch arrangement **37** of FIG. 6a can be used. In this arrangement, electrical current is blocked in the minus-to-positive direction by blocking diode **39.**

Current flow in the positive-to-negative direction is controlled by internal switch **38** according to the application of control signal **40.** Controllable switch **38** provides the capability for the load controller to interrupt power in cases where an unauthorized source of power has been connected to the load terminals or where the source controller malfunctions and can no longer interrupt power from source **1.** In applications such as battery charging, uncontrolled overcharging can result in battery damage or fire, thus making a controllable load disconnect switch advantageous. The transistor type used for internal switch **38** is chosen based on the voltage and current requirements. Industry standard transistors that can be used include FETs, IGBTs or IGCTs. The electrical implementation of control signal **40** for controlling the conduction of internal switch **38** is dependent on the type of transistor but is well known to those skilled in the art of power electronics.

In cases where it is not necessary for load controller **9** to have the ability to interrupt power to the load terminals, internal switch **38** can be constructed as shown in FIG. 6c using only diode **39** to block electrical current from back-flowing from the load circuit into load capacitor C_{load}**4**.

For AC power distribution, which does not fall under the scope of the claims, the AC disconnect switch arrangement **41** of FIG. 6b can be used. In this arrangement, internal switches **43** or **46** acting independently can block electrical current in only one direction since current flow in the opposite direction of each switch is allowed by bypass diodes **42** or **45.** However, by the combined action of ON/OFF control signals **44, 47** electrical current through disconnect switch **41** can be blocked in either direction or in both directions. To block current flow in both directions, control signals **44, 47** are both set to the OFF state, placing internal switches **43, 46** in an open (non-conducting state). To allow current flow in the positive-to-negative direction, while blocking flow in the negative-to-positive direction, internal switch **46** is placed in a closed (conducting) state. Electrical current is then free to flow from the positive terminal through bypass diode **42,** through internal switch **46** and out the negative terminal. Conversely, to allow current flow in the negative-to-positive direction, while blocking the flow in the positive-to-negative direction, internal switch **43** is placed in a closed (conducting) state. Electrical current is then free to flow from the negative terminal through bypass diode **45** through internal switch **43** and out the positive terminal. The transistor types used to implement internal switches **43, 46** are chosen based on the electrical voltage and current requirements. Industry standard transistors that can be used include FETs, IGBTs or IGCTs. The electrical implementation of control signals **44, 47** for controlling the conduction of internal switches **43, 46** is dependent on the type of transistors used, but is well known to those skilled in the art of power electronics.

As shown in FIG. 2, source controller **5** includes microprocessor **20,** communication drivers **17, 22** and signal conditioning circuits **24, 26, 28.** The load controller **9** of FIG. 1 is similar in construction to the source controller but is configured with different operating software to perform the functions described in the operation sequence section, below. Referring to FIG. 1, before beginning operation, self-check and initialization steps are performed in steps (a),(b) and (c). S1 disconnect switch **7** and S2 disconnect switch **13** (if controllable) are commanded to remain in an open (non-conducting) state during initialization.

### Operational Sequence

a) Referring to FIG. 1, the source controller **5** verifies that the source voltage at point **33** is within a predetermined expected value and that there is no current flowing in the source power conductors, as reported by the current sensor **8.** The source controller **5** also performs a built-in testing algorithm, as is typical in the industry, to verify that its hardware and firmware is functioning properly.
b) If the embodiment incorporates advanced monitoring options, a communication check is performed by the source controller through communication link **11** to load controller **9.** For distribution systems that provide secured energy transfer, the source controller **5** will expect a digital verification code that matches a predetermined value to ensure that the source and load equipment are electrically compatible and authorized to receive power before energy transfer is initiated. For example, a verification code may be necessary for applications where the energy is being purchased. The source controller **5** sends a request via communication link **11** to the load controller **9** asking it for its status. The load controller **9** responds with the value of voltage and current on its conductors and any fault codes. The source controller **5** verifies that the load voltage is within a predetermined value and that there is no current flowing in the load power conductors (indicating a possible failed source disconnect, failed current sensors or other hardware problem). The load controller **9** also performs built-in testing algorithms, as is typical in the industry, to verify that its hardware and firmware are functioning properly. If there is no fault registered, the sequence progresses to step (c). If a fault is registered, the sequence is repeated starting at step (a).
c) Source controller **5** makes another measurement of the source voltage at point **33** to determine the duration of the transfer period, where energy will be transferred from the source to the load. The higher the source voltage, the higher the potential fault current, and hence the shorter the transfer period. The source voltage measurement is applied to an internal table or function in the processor of the source controller **5** to determine a safe duration value for the transfer period. The use of a variable transfer period is not required for the operation of the disclosed invention, but will make energy transfer more efficient and less prone to false alarms, since the number of measurements can be maximized and the amount of switching instances can be minimized according the length of the period. The alternative is to maintain a fixed duration transfer period that is configured for the highest possible source voltage and for the worst-case safety conditions.
d) Following the determination of the transfer period, the source controller **5** closes switch S1. If the load circuit incorporates a controllable disconnect switch, the load controller **9** will sense the rapid increase in voltage across capacitor C_{load}**4** measured by voltage sensor at point **35,** and immediately close switch S2 **13.** No action is necessary if the load circuit uses a diode as a disconnect switch. Both controllers **5, 9** continue to measure voltage and current at their respective terminals.
e) At the end of the transfer period, the sample period begins. The source controller **5** measures the voltage across C_{load} at point **34** and then opens switch S1. If the load circuit incorporates a controllable disconnect switch, the load controller **9** senses the rapid decrease in voltage across C_{load} when S1 is opened and immediately opens switch S2. No action is necessary from the load controller **9** if it is employing a diode as a disconnect switch.
f) Immediately after S1 is opened, the source controller measures the voltage across C_{load} at point **34** and the current through the source terminals using the current sensor **8.** If the current value is not approximately zero, a hardware fault is registered, disconnect switch S1 is left in an open state, and the sequence skips to step (j). If there is no fault registered, the operational sequence continues to step (g).
g) The source controller **5** calculates the line resistance from the voltage and current samples acquired in step (d),(e),(f) using one of the two methods described above in the Summary section. If there is no serial communication employed between the source and load controllers, the difference in voltage at point **34** of FIG. 1 before and immediately after S1 is opened is divided by current to calculate line resistance. If the source and load controller **5, 9** are equipped with serial communications, the source controller **5** can request the load voltage reading from the load controller **9** to calculate the voltage difference between the source side and the load side. Dividing the voltage difference by current returns a value for line resistance. If the line resistance is greater than a predetermined maximum value, an in-line fault is registered by the source controller **5.** A calculated line resistance less than a predetermined minimum value is indicative of a hardware failure. If a fault is registered, the source controller **5** immediately opens S1 and proceeds to step (j). If there are no faults registered, the sequence progresses to step (h).
h) Switch S1 remains in the open state until the end of the sample period. At the end of the sample period, but before S1 is closed again, the source controller measures the voltage of C_{load} at point **34,** and compares the voltage reading to the voltage reading that was acquired at the beginning of the sample period. If the voltage has decayed too quickly by being less than a first predetermined value, then a cross-line fault is registered. If it has decayed too slowly and has failed to drop to less than a second predetermined value, it is an indication that the line resistance may be too high or that there is a hardware failure. If a fault has been registered, the sequence skips to step (j). If there are no faults registered, the operational sequence continues on to step (i).
i) If there are no faults registered, the operational sequence repeats, starting at step (c); otherwise, the sequence continues to step (j) below.
j) The power distribution system is in a faulted state due to an in-line fault, cross-line fault or hardware failure. In particular embodiments, the system will allow configuration of either an automatic reset or manual reset from a faulted state. If the system is configured for manual reset, it will remain with the S1 switch open until an outside system or until an operator initiates a restart. The system will then restart the operational sequence from step (a). If the system is configured for automatic restart, then a delay period is executed by the source controller to limit stress on equipment or personnel that may still be in contact with the power distribution conductors. In particular embodiments, the period is from 1 to 60 seconds. The system then restarts the operational sequence from step (a). For an additional level of safety, mechanical contactors may be included in series with S1 and/or S2 to act as redundant disconnects in the event that either S1 or S2 have malfunctioned.

### Summary, Ramifications and Scope

Described herein is a novel power distribution system that can safely transfer energy from a source to a load while overcoming the deficiencies of conventional circuit protection devices and ground fault interrupters.

In its simplest form, the present invention can be configured to only sense a cross-line fault such as would occur if an individual simultaneously touches both link conductors. In this case, only the voltage across the source terminals in position **34** of FIG. 1 are measured to recognize the fault.

In the preferred embodiment, where the load disconnect device is controllable, as described above in the Summary, section, a "sample period" is initiated by opening source disconnect switch S1 **7** of FIG. 1. Load controller **9** senses the rapid voltage drop on C_{load} when S1 is opened and immediately opens disconnect switch S2 **13** to begin the sample period. Using communication link **11,** the action of opening S2 can be initiated by the source controller **5** sending a communication command to the load controller **9** and by the load controller **9** commanding the load disconnect device to an open or closed state rather than having the load controller **9** sense the voltage drop on C_{load} as the trigger to open the load disconnect device.

The components C_{load} **4** and R_{src} **2** of FIG. 1 respectively represent the capacitance and resistance, as seen at the source **31a, 31b** and load terminals **32a, 32b** when switch S1 **7** and S2 **13** are in an open (non-conducting state). In particular embodiments, these components are discrete components, of known value, placed across the source and load terminal conductors. However, the capacitance and resistance of the conductors, even without the discrete components, have an intrinsic value of resistance and capacitance due to their physical construction. In some instances, the system can be operated by programming the source controller **5** with these intrinsic values, thus negating a need to install discrete resistor and capacitor components.

In some examples useful for understanding the invention, energy may flow as described below, as exemplified in a "grid-connected" application, such as a home with an alternative energy source, such as a photovoltaic solar array. At night, the home would act as the load device **3** with the utility grid being the source of energy; but, during the day, the home may become a source **1** rather than a load **3** when it generates solar electricity to be sold back to the grid. In such a case, the operation of the system is essentially the same as what was described, above, in the detailed description. Since the source and load controllers **5, 9** detect both the magnitude and polarity of the electrical current and voltage within the power distribution system, the source controller **5** inherently starts executing this new mode of operation. For example, as described in the detailed operation section, the voltage drop in the power-distribution-system conductors is calculated by multiplying the line current by a worst-case line resistance. When the load starts supplying power rather than sinking power, the polarity of electrical current will reverse and the line drop calculation will still be valid.

Source controller **5** and load controller **9** can include a logic device, such as a microprocessor, microcontroller, programmable logic device or other suitable digital circuitry for executing the control algorithm. The load controller **9** may take the form of a simple sensor node that collects data relevant to the load side of the system. It does not necessarily require a microprocessor.

The controllers **5** and **9** can be computing devices and the systems and methods of this disclosure can be implemented in a computing system environment. Examples of well-known computing system environments and components thereof that may be suitable for use with the systems and methods include, but are not limited to, personal computers, server computers, hand-held or laptop devices, tablet devices, smart phones, multiprocessor systems, microprocessor-based systems, set top boxes, programmable consumer electronics, network PCs, minicomputers, mainframe computers, distributed computing environments that include any of the above systems or devices, and the like. Typical computing system environments and their operations and components are described in many existing patents (*e.g*., US Patent No. 7,191,467, owned by Microsoft Corp.).

The methods may be carried out via non-transitory computer-executable instructions, such as program modules. Generally, program modules include routines, programs, objects, components, data structures, and so forth, that perform particular tasks or implement particular types of data. The methods may also be practiced in distributed computing environments where tasks are performed by remote processing devices that are linked through a communications network. In a distributed computing environment, program modules may be located in both local and remote computer storage media including memory storage devices.

The processes and functions described herein can be non-transitorially stored in the form of software instructions in the computer. Components of the computer may include, but are not limited to, a computer processor, a computer storage medium serving as memory, and a system bus that couples various system components including the memory to the computer processor. The system bus can be of any of several types of bus structures including a memory bus or memory controller, a peripheral bus, and a local bus using any of a variety of bus architectures.

The computer typically includes one or more a variety of computer-readable media accessible by the processor and including both volatile and nonvolatile media and removable and non-removable media. By way of example, computer-readable media can comprise computer-storage media and communication media.

The computer storage media can store the software and data in a non-transitory state and includes both volatile and nonvolatile, removable and non-removable media implemented in any method or technology for storage of software and data, such as computer-readable instructions, data structures, program modules or other data. Computer-storage media includes, but is not limited to, RAM, ROM, EEPROM, flash memory or other memory technology, CD-ROM, digital versatile disks (DVD) or other optical disk storage, magnetic cassettes, magnetic tape, magnetic disk storage or other magnetic storage devices, or any other medium that can be used to store the desired information and that can accessed and executed by the processor.

The memory includes computer-storage media in the form of volatile and/or nonvolatile memory such as read only memory (ROM) and random access memory (RAM). A basic input/output system (BIOS), containing the basic routines that help to transfer information between elements within the computer, such as during start-up, is typically stored in the ROM. The RAM typically contains data and/or program modules that are immediately accessible to and/or presently being operated on by the processor.

The computer may also include other removable/non-removable, volatile/nonvolatile computer-storage media, such as (a) a hard disk drive that reads from or writes to non-removable, nonvolatile magnetic media; (b) a magnetic disk drive that reads from or writes to a removable, nonvolatile magnetic disk; and (c) an optical disk drive that reads from or writes to a removable, nonvolatile optical disk such as a CD ROM or other optical medium. The computer-storage medium can be coupled with the system bus by a communication interface, wherein the interface can include, e.g., electrically conductive wires and/or fiber-optic pathways for transmitting digital or optical signals between components. Other removable/non-removable, volatile/nonvolatile computer storage media that can be used in the exemplary operating environment include magnetic tape cassettes, flash memory cards, digital versatile disks, digital video tape, solid state RAM, solid state ROM, and the like.

The drives and their associated computer-storage media provide storage of computer-readable instructions, data structures, program modules and other data for the computer. For example, a hard disk drive inside or external to the computer can store an operating system, application programs, and program data.

The source and load controllers **5, 9** can be used to meter energy transfer and communicate the information back to the user or a remote location. For example, the disclosed invention can be implemented on an electric vehicle public charging station and can be utilized to send electricity consumption back to a central credit card processor. The transfer of information can be through an outside communication link **15,** as depicted in FIG. 1. A user can also be credited for electricity that is transferred from his electric vehicle and sold to the power grid. The outside communication link **15** can also be used to transfer other operational information. For example, an electric vehicle can have contacts under its chassis that drop down make connection to a charging plate embedded in a road surface. The communication link **15** can transfer proximity information indicating that the car is over the charging plate. The information can inhibit energizing the charger plate unless the car is properly positioned.

The source disconnect device **7** can be supplemented by the addition of an electromechanical relay or "contactor" providing a redundant method to disconnect the source **1** from the source terminals so as to provide a back-up in the case of a failure of the source disconnect device **7.** The load disconnect device **13** can be supplemented by an electromechanical relay or contactor in the same fashion. The electromechanical contactor activation coils can be powered by what is known to those skilled in the art as a "watchdog circuit". The watchdog circuit continually communicates with by the source or load controllers **5, 9;** otherwise, the contactor will automatically open, providing a fail-safe measure against "frozen" software or damaged circuitry in the controllers **5, 9.**

The source controller **5** can be programmed with an algorithm that adjusts the ratio of time that the source disconnect device **7** is conducting in respect to the time that it is not conducting in order to regulate the amount of energy transfer from the source **1** to the load **3.** This method is well known to those skilled in the art as "pulse width modulation".

Data communications link **11** and/or external communication link **15** can be implemented using various methods and protocols well known to those skilled in the art. Communication hardware and protocols can include RS-232, RS-485, CAN bus, Firewire and others. The communication link **11** can be established using copper conductors, fiber optics or wirelessly over any area of the electromagnetic spectrum allowed by regulators, such as the Federal Communications Commission (FCC), as set forth in Part 18 of the FCC Rules. Wireless communication can be established using any of a number of protocols well known to those skilled in the art, including Wi-Fi, IRDa, Wi-Max and others. The data communications link **11** can communicate operating information between the source controller and the load controller, wherein the operating information includes at least a value indicative of the voltage across the load terminals that is acquired by the load controller.

Another option for implementing the functions of communication link **11** and/or external communication link **15** of FIG. 1 is what is referred to those skilled in the art as "communication over power lines", or "communication or power line carrier" (PLC), also known as "power line digital subscriber line" (PDSL), "mains communication", or "broadband over power lines" (BPL). Referring to the revised source controller of FIG. 7, communication signals generated by microprocessor **20** are superimposed on the source terminals using a modulator/demodulator **48.** The hardware and software methods of modulator/demodulator **48** are well known to those skilled in the art. Although the source controller is used as an example, an identical implementation of the modulator/demodulator **48** can be contained in the load controller, allowing bidirectional communication between the source and load controller. The transmitting side, either the source or load, combines the communication signals with the power waveform on the source or load terminals. The receiving side, either the source or the load, would then separate the communication signals from the power waveform.

To allow simultaneous power transfer and user-data communications, the system can be configured as depicted in FIG. 9. In one example, a CAT 5 communication cable is used to transfer Ethernet data between an end-user's computer and an Ethernet switch; and the same cable conductors can be used to provide 400-600 Watts of power to the computer, itself, using the methods described herein. Referring to FIG. 9, source circuitry **50** can include all of the source components; or, referring to FIG. 1, the source circuitry can include source **1,** source controller **5,** source disconnect device **7** and all related source components. Load Circuitry **51** can represents all of the load components; or, referring to FIG. 1, the load circuitry **51** can include load **3,** load controller **9,** load disconnect device **13** and all related load components. The output conductors of source circuitry **50** are applied to the center tap points of isolation transformers **52** and **54** on the source side of the configuration. Corresponding center tap points on isolation transformers **53** and **55** are on the load side of the configuration and are electrically connected to center points on transformers **52** and **54** through the transformer windings. On the source side, Ethernet data can be applied to the windings of transformers **52** and **54** that are electrically isolated from the center-tapped side using a balanced conductor pair configuration that is well known to those in the industry. On the load side, the pairs are picked up on the corresponding windings of transformers **53** and **55** that are electrically isolated from the center-tapped side containing the power. Because the power is essentially direct current, it passes through the transformers on the source side to the load side without causing magnetic excitation and, therefore, does not corrupt the data that is also resident on the communication lines. The described hardware configuration of center-tapped transformers is commonly used in the industry for implementing power over Ethernet (PoE) as is described in PoE standard IEEE-802.3a. PoE does not have the safety features, described herein, and is therefore limited to approximately 48V to avoid the possibility of electrical shock.

Thus the scope of the disclosed invention should be determined by the appended claims and their legal equivalents, rather than the examples given. In describing embodiments of the invention, specific terminology is used for the sake of clarity. For the purpose of description, specific terms are intended to at least include technical and functional equivalents that operate in a similar manner to accomplish a similar result. Additionally, in some instances where a particular embodiment of the invention includes a plurality of system elements or method steps, those elements or steps may be replaced with a single element or step; likewise, a single element or step may be replaced with a plurality of elements or steps that serve the same purpose. Moreover, while this invention has been shown and described with references to particular embodiments thereof, those skilled in the art will understand that various substitutions and alterations in form and details may be made therein without departing from the scope of the invention. Further still, other aspects, functions and advantages are also within the scope of the invention; and all embodiments of the invention need not necessarily achieve all of the advantages or possess all of the characteristics described above. Additionally, steps, elements and features discussed herein in connection with one embodiment can likewise be used in conjunction with other embodiments. Still further, the components, steps and features identified in the Background section are integral to this disclosure and can be used in conjunction with or substituted for components and steps described elsewhere in the disclosure within the scope of the invention. In method claims, where stages are recited in a particular order-with or without sequenced prefacing characters added for ease of reference-the stages are not to be interpreted as being temporally limited to the order in which they are recited unless otherwise specified or implied by the terms and phrasing.

## Claims

1. A DC power distribution system for regulating transfer of energy from a source (1) on a source side and including source terminals (31a, 31b) to a load circuit (3) on a load side and including load terminals (32a, 32b) with attached capacitance (C_{load}, 4), the system comprising:
a) a source controller (5) on the source side of the power distribution system responsive to a source sensor (8) that provides feedback to the source controller (5) that includes at least a signal indicative of a voltage across the source terminals (31a, 31b);
b) a source disconnect device (7) responsive to a control signal from the source controller (5) for electrically connecting or disconnecting the source (1) from the source terminals (31a, 31b), wherein the source controller (5) is configured to periodically interrupt the supply of DC power to the load circuit (3) by opening the source disconnect device (7);
c) a load disconnect device (13) configured to electrically decouple the load circuit (3) from the load terminals (32a, 32b) with the opening of the source disconnect device (7) such as to block at least electrical current from back-flowing from the load circuit (3) into the capacitance (C_{load}, 4); and
d) a logic device implemented in at least the source controller (5) configured
• to open the source disconnect device (7),
• to perform a first source terminal voltage measurement,
• to perform a second source terminal voltage measurement after a predetermined time has expired since the first source terminal voltage measurement and with the source disconnect device (7) still opened and with the load disconnect device (13) still decoupling the load circuit (3) from the load terminals (32a, 32b), wherein the difference in the voltage measurements is representative of impedance between the source terminals (31a, 31b) and a corresponding discharge rate of capacitance (C_{load,} 4) between the source terminals (31a, 31b),
• to determine whether the difference in the voltage measurements falls outside of predetermined high and low limits, wherein a difference in the voltage measurements outside of the predetermined high and low limits indicates that there is a foreign object or individual making contact with the source or load terminals (32a, 32b) or a failure in the power distribution system hardware, and
• to only close the source disconnect device (7), and the load disconnect device (13) if the load disconnect device is controllable, if the difference in the voltage measurements falls within the predetermined high and low limits.

2. The power distribution system of claim 1, further comprising a load controller (9) on the load side of the power distribution system responsive to a load sensor (8) that provides feedback to the load controller (9) that includes at least a signal indicative of the voltage across the load terminals (32a, 32b).

3. The power distribution system of claim 2, further comprising a data communication link (11) configured for the exchange of operating information between the source controller (5) and the load controller (9), wherein the operating information includes at least a value indicative of the voltage across the load terminals (32a, 32b) that is acquired by the load controller (9).

4. The power distribution system of claim 3, wherein the data communication link (11) comprises wireless communication circuits operating at carrier frequencies within the electromagnetic spectrum allowed by federal regulators.

5. The power distribution system of claim 3, wherein the source controller (5) and the load controller (9) include modems, wherein the data communication is accomplished by the modems in the source and load controllers (5, 9) that are operable to combine a communication signal with the voltage waveforms present on the source or load terminals (31a/32a, 31b/32b), and to later separate the communication signal from the voltage waveforms present on the source or load terminals (31a/32a, 31b/32b), such that the source and load controllers (5, 9) can communicate with each other using only the connections between the source and load terminals (31a, 32a, 31b, 32b).

6. The power distribution system of claim 5, wherein the data communication is accomplished only when the source (1) is disconnected from the source terminals (31a, 31b), wherein the communication signals are not disrupted by electrical current flowing from the source terminals (31a, 31b) to the load terminals (32a, 32b).

7. The power distribution system of claim 3, wherein the source and load controllers (5, 9) exchange a digital verification code that must match a predetermined value before energy transfer can be initiated.

8. The power distribution system of claim 2, wherein the source controller (5) is configured to calculate the difference between the source terminal voltage acquired by the source controller (5) and the load terminal voltage acquired by the load controller (9) and to issue a command to open the source disconnect device (7) if the difference does not fall between predetermined high and low values.

9. The power distribution system of claim 1, wherein the source disconnect device (7) is responsive to a control signal from the source controller (5) to vary the ratio of time that the source (1) is connected to the source terminals (31a, 31b) in relationship to the time the source (1) is disconnected from the source terminals (31a, 31b) so as to regulate the average energy transferred from the source (1) to the load circuit (3).

10. The power distribution system of claim 1, further comprising a current sensor (8) that allows the source controller (5) to acquire a signal indicative of the electrical current flowing from the source (1) to the source terminals (31a, 31b), and wherein the source controller (5) is configured to open the source disconnect device (7) to disconnect the source (1) from the source terminals (31a, 31b) if the electrical current exceeds a predetermined maximum value.

11. The power distribution system of claim 10, wherein the source controller (5) is configured to periodically multiply the source terminal voltage measurements with the source current measurements resulting in a calculated instantaneous power value and to integrate consecutive power values to derive a total energy value.

12. The power distribution system of claim 11, wherein the source controller (5) is also configured to apply a financial charge to the user for energy extracted from the source.

13. The power distribution system of claim 1, wherein the load disconnect device (13) comprises a diode (39).

14. A method for implementing a DC power distribution system for the transfer of energy from a source (1) to a load circuit (3) via source terminals (31a, 31b) and load terminals (32a, 32b) via a direct current, where the DC power distribution system is configured to detect unsafe conditions that include electrically conducting foreign objects or individuals that have come in contact with exposed conductors in the power distribution system, the method comprising the steps of:
a) generating a responsive signal in a source controller (5) to open a source disconnect device (7), resulting in the interruption of the electrical connection between the source (1) and the source terminals (31a, 31b) and in a decoupling by a load disconnect device (13) such as to block at least electrical current from back-flowing from the load circuit (3) into the load terminals (32a, 32b) to which a capacitance (C_{load}, 4) is attached;
b) with the source disconnect device (7) opened and with the load circuit electrically decoupled from the load terminals (32a, 32b), acquiring a first measurement of the voltage across the source terminals (31a, 31b) using a source terminal voltage sensor (34), and storing the first voltage measurement for access by the source controller (5);
c) after a predetermined time has expired, with the source disconnect device (7) still opened and the load circuit (3) still electrically decoupled from the load terminals (32a, 32b), acquiring a second measurement of the voltage of the source terminals (31a, 31b) using the source terminal voltage sensor (34) and storing the second voltage measurement for access by the source controller (5);
d) calculating the difference between the first stored voltage measurement and the second stored voltage measurement, wherein the difference represents the discharge rate of the capacitance across the source and load terminals (31a, 31b, 32a, 32b); and
e) generating signals from the source controller (5) to close the source disconnect device (7), and the load disconnect device (13) if the load disconnect device is controllable, if the difference between the first stored voltage measurement and the second stored voltage measurement falls within predetermined high and low limits, wherein a discharge rate outside of the predetermined high and low limits indicates that there is a conducting foreign object or individual making electrical contact with the source or load terminals (31a/32a, 3 1b/32b), or a failure in the DC power distribution system hardware.

15. The method of claim 14, wherein the source controller (5) communicates with a load controller (9) using at least one of an optical, conductive and wireless communication link (11).

16. The method of claim 15, wherein the source controller (5) acquires a digital verification code from the load controller (9) via the communication link (11) and acts cause the source disconnect device (7) to remain in an open state if the digital verification code does not match a previously stored code resident in memory of the source controller (5).

17. The method of claim 14, wherein the source controller (5) acts to vary the conductive time period of the source disconnect device (7) in relation to the non-conductive time period of the source disconnect device (7) such that the average energy transferred from the source (1) to the load circuit (3) can be regulated according to an algorithm being executed by the source controller (5).

18. The method of claim 14, further comprising:
f) executing code in the source controller (5) to acquire a measurement of the electrical current flowing through the source terminals (31a, 31b) using a current sensor (8);
g) storing the electrical current value in the source controller memory; and
h) opening the source disconnect device (7) to disconnect the source (1) from the source terminals (31a, 31b) if the electrical current exceeds a predetermined maximum value.

19. The method of claim 14, further comprising executing an algorithm in the source controller (5) to calculate the difference between the source terminal voltage acquired by the source controller (5) using the source terminal voltage sensor (34) and the load terminal voltage acquired by the source controller (5) from a load controller (9), and acting to open the source disconnect device (7) if the difference between the source terminal voltage and the load terminal voltage does not fall between predetermined high and low limits.

20. The method of claim 14, further comprising, at the source controller (5):
f) acquiring a measurement of the electrical current flowing through the source terminals (31a, 31b) using a current sensor (8);
g) acquiring a measurement of the source terminal voltage using a voltage sensor (34);
h) periodically multiplying the source terminal voltage measurements by the source current measurements to derive an instantaneous power value; and
i) integrating consecutive calculated power values with respect to time to derive a total energy value.

21. The method of claim 20, further comprising applying a financial charge to a user of the energy for energy extracted by the user from the source (1).

22. The method of claim 14, wherein the source controller (5) acquires a first measurement of the source terminal voltage using a voltage sensor (34) while the source disconnect device (7) is closed then acquires a second measurement of the source terminal voltage immediately after the source disconnect device (7) is opened and computes the difference between the first and second voltage measurement, and where the source controller (5) takes action to open the source disconnect device (7) if the voltage difference falls outside of predetermined high or low limits.

23. The method of claim 22, wherein the source controller (5) also acquires a measurement of the electrical current flowing through the source terminals (31a, 31b) using the current sensor (8) while the source disconnect device (7) is closed, and divides the voltage difference by the current measurement to derive a value for the resistance of the conductors between the source terminals (31a, 31b) and the load terminals (32a, 32b), and where the source controller (5) takes action to open the source disconnect device (7) if the resistance value falls outside of predetermined high and low limits.

24. The method of claim 14, further comprising connecting a first source circuitry output conductor to a center tap point on a secondary coil of a first isolation transformer (52) and connecting a second source circuitry output conductor to a center tap point on a secondary coil of a second isolation transformer (54), and where a first load circuitry input conductor is connected to a center tap point on a primary coil of a third isolation transformer (53) and a second load circuitry input conductor is connected to a center tap point of a primary coil on a fourth isolation transformer (55), such that the configuration substantially cancels any flux produced in the four transformers (52-55) due to current flowing from the source circuitry (50) to the load circuitry (51), and where the remaining unused terminals of the four transformers (52-55) can be used to transmit and receive data that is electrically isolated and independent of electrical current flowing from the source circuitry (50) to the load circuitry (51).

25. The method of claim 24, wherein the data is communicated using Ethernet technology.

26. The method of claim 24, wherein the data is communicated using Digital Subscriber Line technology.

## Patentansprüche

1. Gleichstrom-Leistungsverteilungssystem zum Regeln der Übertragung von Energie von einer Quelle (1) auf einer Quellenseite und aufweisend Quellenanschlüsse (31a, 31b) zu einer Lastschaltung (3) auf einer Lastseite und aufweisend Lastanschlüsse (32a, 32b) mit angeschlossener Kapazität (C_{Last}, 4), wobei das System Folgendes umfasst:
a) einen Quellencontroller (5) auf der Quellenseite des Leistungsverteilungssystems, der auf einen Quellensensor (8) reagiert, der Rückmeldung an den Quellencontroller (5) liefert, die mindestens ein Signal beinhaltet, das eine Spannung über den Quellenanschlüssen (31a, 31b) angibt;
b) eine Quellenabwurfvorrichtung (7), die auf ein Steuersignal von dem Quellencontroller (5) reagiert, zum elektrischen Verbinden oder Trennen der Quelle (1) mit bzw. von den Quellenanschlüssen (31a, 31b), wobei der Quellencontroller (5) ausgelegt ist zum periodischen Unterbrechen der Zufuhr von Gleichstromleistung zu der Lastschaltung (3) durch Öffnen der Quellenabwurfvorrichtung (7);
c) eine Lastabwurfvorrichtung (13), die ausgelegt ist zum elektrischen Abkoppeln der Lastschaltung (3) von den Lastanschlüssen (32a, 32b) mit dem Öffnen der Quellenabwurfvorrichtung (7), um somit zumindest elektrischen Strom vom Rückfluss von der Lastschaltung (3) in die Kapazität (C_{Last}, 4) zu blockieren; und
d) eine Logikvorrichtung, die zumindest in dem Quellencontroller (5) implementiert ist, ausgelegt zum
• Öffnen der Quellenabwurfvorrichtung (7),
• Durchführen einer ersten Quellenanschluss-Spannungsmessung,
• Durchführen einer zweiten Quellenanschluss-Spannungsmessung, nachdem eine vorbestimmte Zeit seit der ersten Quellenanschluss-Spannungsmessung vergangen ist, und mit der Quellenabwurfvorrichtung (7) weiterhin geöffnet und mit der Lastabwurfvorrichtung (13) weiterhin die Lastschaltung (3) von den Lastanschlüssen (32a, 32b) abkoppelnd, wobei die Differenz der Spannungsmessungen eine Impedanz zwischen den Quellenanschlüssen (31a, 31b) und eine entsprechende Entladungsrate der Kapazität (C_{Last}, 4) zwischen den Quellenanschlüssen (31a, 31b) repräsentiert,
• Bestimmen, ob die Differenz der Spannungsmessungen außerhalb von vorbestimmten Hoch- und Tiefgrenzen fällt, wobei eine Differenz der Spannungsmessungen außerhalb der vorbestimmten Hoch- und Tiefgrenzen angibt, dass es ein Fremdobjekt oder ein Individuum, das mit der Quelle oder den Lastanschlüssen (32a, 32b) Kontakt herstellt, oder ein Versagen der Leistungsverteilungssystemhardware gibt, und
• Schließen der Quellenabwurfvorrichtung (7) und der Lastabwurfvorrichtung (13) nur dann, wenn die Lastabwurfvorrichtung steuerbar ist, wenn die Differenz der Spannungsmessungen innerhalb der vorbestimmten Hoch- und Tiefgrenzen fällt.

2. Leistungsverteilungssystem nach Anspruch 1, ferner umfassend einen Lastcontroller (9) auf der Lastseite des Leistungsverteilungssystems, der auf einen Lastsensor (8) reagiert, der Rückmeldung an den Lastcontroller (9) liefert, die mindestens ein Signal beinhaltet, das eine Spannung über den Lastanschlüssen (32a, 32b) angibt.

3. Leistungsverteilungssystem nach Anspruch 2, ferner umfassend einen Datenkommunikationslink (11), der ausgelegt ist zum Austausch von Betriebsinformationen zwischen dem Quellencontroller (5) und dem Lastcontroller (9), wobei die Betriebsinformationen zumindest einen Wert enthalten, der die Spannung über den Lastanschlüssen (32a, 32b) angibt, die durch den Lastcontroller (9) erfasst wurde.

4. Leistungsverteilungssystem nach Anspruch 3, wobei der Datenkommunikationslink (11) drahtlose Kommunikationsschaltungen umfasst, die auf Trägerfrequenzen innerhalb des elektromagnetischen Spektrums arbeiten, die durch Bundesbehörden zugelassen sind.

5. Leistungsverteilungssystem nach Anspruch 3, wobei der Quellencontroller (5) und der Lastcontroller (9) Modems beinhalten, wobei die Datenkommunikation durch die Modems in dem Quellen- und dem Lastcontroller (5, 9) erreicht wird, die betreibbar sind zum Kombinieren eines Kommunikationssignals mit den auf den Quellen- oder den Lastanschlüssen (31a/32a, 31b/32b) vorhandenen Spannungswellenformen, und später zum Trennen des Kommunikationssignals von den auf den Quellen- oder den Lastanschlüssen (31a/32a, 31b/32b) vorhandenen Spannungswellenformen, so dass der Quellen- und der Lastcontroller (5, 9) miteinander unter Verwendung nur der Verbindungen zwischen den Quellen- und den Lastanschlüssen (31a, 32a, 31b, 32b) kommunizieren können.

6. Leistungsverteilungssystem nach Anspruch 5, wobei die Datenkommunikation nur erreicht wird, wenn die Quelle (1) von den Quellenanschlüssen (31a, 31b) getrennt ist, wobei die Kommunikationssignale nicht durch elektrischen Strom gestört werden, der von den Quellenanschlüssen (31a, 31b) zu den Lastanschlüssen (32a, 32b) fließt.

7. Leistungsverteilungssystem nach Anspruch 3, wobei der Quellen- und der Lastcontroller (5, 9) einen digitalen Verifikationscode austauschen, der mit einem vorbestimmten Wert übereinstimmen muss, bevor Energieübertragung eingeleitet werden kann.

8. Leistungsverteilungssystem nach Anspruch 2, wobei der Quellencontroller (5) ausgelegt ist zum Berechnen der Differenz zwischen der durch den Quellencontroller (5) erfassten Quellenanschlussspannung und der durch den Lastcontroller (9) erfassten Lastanschlussspannung und zum Ausgeben eines Befehls, die Quellenabwurfvorrichtung (7) zu öffnen, wenn die Differenz nicht zwischen die vorbestimmten Hoch- und Tiefwerte fällt.

9. Leistungsverteilungssystem nach Anspruch 1, wobei die Quellenabwurfvorrichtung (7) auf ein Steuersignal von dem Quellencontroller (5) reagiert, das Verhältnis von Zeit, für welche die Quelle (1) mit den Quellenanschlüssen (31a, 31b) verbunden ist, in Relation zu der Zeit, für welche die Quelle (1) von den Quellenanschlüssen (31a, 31b) getrennt ist, zu variieren, um somit die mittlere von der Quelle (1) zur Lastschaltung (3) übertragene Energie zu regeln.

10. Leistungsverteilungssystem nach Anspruch 1, ferner umfassend einen Stromsensor (8), der es dem Quellencontroller (5) erlaubt, ein Signal zu erfassen, das den elektrischen Strom angibt, der von der Quelle (1) zu den Quellenanschlüssen (31a, 31b) fließt, und wobei der Quellencontroller (5) ausgelegt ist zum Öffnen der Quellenabwurfvorrichtung (7), um die Quelle (1) von den Quellenanschlüssen (31a, 31b) zu trennen, wenn der elektrische Strom einen vorbestimmten Maximalwert übersteigt.

11. Leistungsverteilungssystem nach Anspruch 10, wobei der Quellencontroller (5) ausgelegt ist zum periodischen Multiplizieren der Quellenanschluss-Spannungsmessungen mit den Quellenstrommessungen, was zu einem berechneten momentanen Leistungswert führt, und zum Integrieren von aufeinanderfolgenden Leistungswerten, um einen Gesamtenergiewert abzuleiten.

12. Leistungsverteilungssystem nach Anspruch 11, wobei der Quellencontroller (5) auch ausgelegt ist zum Auferlegen einer monetären Belastung für den Benutzer für von der Quelle extrahierte Energie.

13. Leistungsverteilungssystem nach Anspruch 1, wobei die Lastabwurfvorrichtung (13) eine Diode (39) umfasst.

14. Verfahren zum Implementieren eines Gleichstrom-Leistungsverteilungssystems für die Übertragung von Energie von einer Quelle (1) zu einer Lastschaltung (3) über Quellenanschlüsse (31a, 31b) und Lastanschlüsse (32a, 32b) mittels Gleichstrom, wobei das Gleichstrom-Leistungsverteilungssystem ausgelegt ist zum Detektieren unsicherer Bedingungen, die elektrisch leitende Fremdobjekte oder Individuen umfassen, die mit freiliegenden Leitern in dem Leistungsverteilungssystem in Kontakt geraten sind, wobei das Verfahren die folgenden Schritte umfasst:
a) Erzeugen eines Reaktionssignals in einem Quellencontroller (5) zum Öffnen einer Quellenabwurfvorrichtung (7), was zur Unterbrechung der elektrischen Verbindung zwischen der Quelle (1) und den Quellenanschlüssen (31a, 31b) und zu einer Abkopplung durch eine Lastabwurfvorrichtung (13) führt, so dass zumindest elektrischer Strom am Rückfließen von der Lastschaltung (3) in die Lastanschlüsse (32a, 32b), an die eine Kapazität (C_{Last}, 4) angeschlossen ist, blockiert wird;
b) mit der Quellenabwurfvorrichtung (7) geöffnet und mit der Lastschaltung elektrisch von den Lastanschlüssen (32a, 32b) abgekoppelt, Erfassen einer ersten Messung der Spannung über den Quellenanschlüssen (31a, 31b) unter Verwendung eines Quellenanschluss-Spannungssensors (34) und Speichern der ersten Spannungsmessung zum Zugriff durch den Quellencontroller (5);
c) nachdem eine vorbestimmte Zeit vergangen ist, mit der Quellenabwurfvorrichtung (7) weiterhin geöffnet und der Lastschaltung (3) weiterhin von den Lastanschlüssen (32a, 32b) abgekoppelt, Erfassen einer zweiten Messung der Spannung der Quellenanschlüsse (31a, 31b) unter Verwendung des Quellenanschluss-Spannungssensors (34) und Speichern der zweiten Spannungsmessung zum Zugriff durch den Quellencontroller (5);
d) Berechnen der Differenz zwischen der ersten gespeicherten Spannungsmessung und der zweiten gespeicherten Spannungsmessung, wobei die Differenz die Entladungsrate der Kapazität über den Quellen- und den Lastanschlüssen (31a, 31b, 32a, 32b) repräsentiert; und
e) Erzeugen von Signalen von dem Quellencontroller (5) zum Schließen der Quellenabwurfvorrichtung (7) und der Lastabwurfvorrichtung (13), wenn die Lastabwurfvorrichtung steuerbar ist, wenn die Differenz zwischen der ersten gespeicherten Spannungsmessung und der zweiten gespeicherten Spannungsmessung innerhalb von vorbestimmten Hoch- und Tiefgrenzen fällt, wobei eine Entladungsrate außerhalb der vorbestimmten Hoch- und Tiefgrenzen angibt, dass es ein leitendes Fremdobjekt oder Individuum, das elektrischen Kontakt mit den Quellen- oder den Lastanschlüssen (31a/32a, 31b/32b) herstellt, oder ein Versagen der Gleichstrom-Leistungsverteilungssystemhardware gibt.

15. Verfahren nach Anspruch 14, wobei der Quellencontroller (5) mit einem Lastcontroller (9) unter Verwendung eines optischen und/oder eines leitenden und/oder eines drahtlosen Kommunikationslinks (11) kommuniziert.

16. Verfahren nach Anspruch 15, wobei der Quellencontroller (5) einen digitalen Verifikationscode von dem Lastcontroller (9) über den Kommunikationslink (11) erfasst und bewirkt, die Quellenabwurfvorrichtung (7) zu veranlassen, in einem Offenzustand zu verbleiben, wenn der digitale Verifikationscode nicht mit einem zuvor gespeicherten Code übereinstimmt, der in einem Speicher des Quellencontrollers (5) residiert.

17. Verfahren nach Anspruch 14, wobei der Quellencontroller (5) bewirkt, den leitenden Zeitraum der Quellenabwurfvorrichtung (7) in Relation zu dem nichtleitenden Zeitraum der Quellenabwurfvorrichtung (7) zu variieren, so dass die mittlere von der Quelle (1) zu der Lastschaltung (3) übertragene Energie gemäß einem Algorithmus, der durch den Quellencontroller (5)ausgeführt wird, geregelt werden kann.

18. Verfahren nach Anspruch 14, ferner umfassend:
f) Ausführen von Code in dem Quellencontroller (5) zum Erfassen einer Messung des elektrischen Stroms, der durch die Quellenanschlüsse (31a, 31b) fließt, unter Verwendung eines Stromsensors (8);
g) Speichern des Werts des elektrischen Stroms in dem Quellencontrollerspeicher; und
h) Öffnen der Quellenabwurfvorrichtung (7) zum Trennen der Quelle (1) von den Quellenanschlüssen (31a, 31b), wenn der elektrische Strom einen vorbestimmten Maximalwert übersteigt.

19. Verfahren nach Anspruch 14, ferner umfassend Ausführen eines Algorithmus in dem Quellencontroller (5) zum Berechnen der Differenz zwischen der unter Verwendung des Quellenanschluss-Spannungssensors (34) durch den Quellencontroller (5) erfassten Quellenanschlussspannung und der durch den Quellencontroller (5) von einem Lastcontroller (9) erfassten Lastanschlussspannung, und Bewirken, die Quellenabwurfvorrichtung (7) zu öffnen, wenn die Differenz zwischen der Quellenanschlussspannung und der Lastanschlussspannung nicht zwischen vorbestimmte Hoch- und Tiefgrenzen fällt.

20. Verfahren nach Anspruch 14, ferner umfassend, an dem Quellencontroller (5):
f) Erfassen einer Messung des durch die Quellenanschlüsse (31a, 31b) fließenden elektrischen Stroms unter Verwendung eines Stromsensors (8);
g) Erfassen einer Messung der Quellenanschlussspannung unter Verwendung eines Spannungssensors (34);
h) periodisches Multiplizieren der Quellenanschluss-Spannungsmessungen mit den Quellenstrommessungen, um einen momentanen Leistungswert abzuleiten; und
i) Integrieren aufeinanderfolgender berechneter Leistungswerte über die Zeit, um einen Gesamtenergiewert abzuleiten.

21. Verfahren nach Anspruch 20, ferner umfassend Auferlegen einer monetären Belastung für einen Benutzer der Energie für durch den Benutzer von der Quelle (1) extrahierte Energie.

22. Verfahren nach Anspruch 14, wobei der Quellencontroller (5) eine erste Messung der Quellenanschlussspannung unter Verwendung eines Spannungssensors (34) erfasst, während die Quellenabwurfvorrichtung (7) geschlossen ist, dann eine zweite Messung der Quellenanschlussspannung erfasst, unmittelbar nachdem die Quellenabwurfvorrichtung (7) geöffnet wurde, und die Differenz zwischen der ersten und der zweiten Spannungsmessung errechnet, und wobei der Quellencontroller (5) Maßnahmen ergreift zum Öffnen der Quellenabwurfvorrichtung (7), wenn die Spannungsdifferenz außerhalb der vorbestimmten Hoch- oder Tiefgrenzen fällt.

23. Verfahren nach Anspruch 22, wobei der Quellencontroller (5) auch eine Messung des durch die Quellenanschlüsse (31a, 31b) fließenden elektrischen Stroms unter Verwendung des Stromsensors (8) erfasst, während die Quellenabwurfvorrichtung (7) geschlossen ist, und die Spannungsmessung durch die Strommessung dividiert, um einen Wert für den Widerstand der Leiter zwischen den Quellenanschlüssen (31a, 31b) und den Lastanschlüssen (32a, 32b) abzuleiten, und wobei der Quellencontroller (5) Maßnahmen ergreift zum Öffnen der Quellenabwurfvorrichtung (7), wenn der Widerstandswert außerhalb von vorbestimmten Hoch- und Tiefgrenzen fällt.

24. Verfahren nach Anspruch 14, ferner umfassend Verbinden eines ersten Quellenbeschaltungsausgangsleiters mit einem Mittelabgriffpunkt an einer Sekundärspule eines ersten Trenntransformators (52) und Verbinden eines zweiten Quellenbeschaltungsausgangsleiters mit einem Mittelabgriffpunkt an einer Sekundärspule eines zweiten Trenntransformators (54), und wobei ein erster Lastbeschaltungseingangsleiter mit einem Mittelabgriffpunkt an einer Primärspule eines dritten Trenntransformators (53) verbunden ist und ein zweiter Lastbeschaltungseingangsleiter mit einem Mittelabgriffpunkt einer Primärspule an einem vierten Trenntransformator (55) verbunden ist, so dass die Ausgestaltung im Wesentlichen jeden in den vier Transformatoren (52-55) produzierten Fluss auslöscht, aufgrund von Strom, der von der Quellenbeschaltung (50) zu der Lastbeschaltung (51) fließt, und wobei die verbliebenen ungenutzten Anschlüsse der vier Transformatoren (52-55) verwendet werden können zum Senden und Empfangen von Daten, die elektrisch isoliert und unabhängig von elektrischem Strom, der von der Quellenbeschaltung (50) zur Lastbeschaltung (51) fließt, sind.

25. Verfahren nach Anspruch 24, wobei die Daten unter Verwendung von Ethernet-Technologie kommuniziert werden.

26. Verfahren nach Anspruch 24, wobei die Daten unter Verwendung von Digital-Subscriber-Line-Technologie kommuniziert werden.

## Revendications

1. Système de distribution de puissance à courant continu pour réguler le transfert d'énergie d'une source (1) du côté source, et comprenant des bornes de source (31a, 31b) à un circuit de charge (3) du côté charge, et comprenant des bornes de charge (32a, 32b) avec une capacité attachée (C_{load}, 4), le système comprenant :
a) un dispositif de commande de source (5) du côté source du système de distribution de puissance réagissant à un capteur de source (8) qui fournit une rétroaction au dispositif de commande de source (5) qui comprend au moins un signal indiquant une tension entre les bornes de source (31a, 31b) ;
b) un dispositif de déconnexion de source (7) réagissant à un signal de commande provenant du dispositif de commande de source (5) pour connecter ou déconnecter électriquement la source (1) des bornes de source (31a, 31b), le dispositif de commande de source (5) étant configuré pour interrompre périodiquement l'alimentation en courant continu du circuit de charge (3) en ouvrant le dispositif de déconnexion de source (7) ;
c) un dispositif de déconnexion de charge (13) configuré pour découpler électriquement le circuit de charge (3) des bornes de charge (32a, 32b) avec l'ouverture du dispositif de déconnexion de source (7) de manière à bloquer au moins le courant électrique pour empêcher le reflux du circuit de charge (3) dans la capacité (C_{load}, 4) ; et
d) un dispositif logique mis en œuvre au moins dans le dispositif de commande de source (5) configuré
• pour ouvrir le dispositif de déconnexion de source (7),
• pour réaliser une première mesure de la tension aux bornes de la source,
• pour réaliser une deuxième mesure de la tension aux bornes de la source après qu'un temps prédéterminé s'est écoulé depuis la première mesure de la tension aux bornes de la source, et avec le dispositif de déconnexion de source (7) encore ouvert et avec le dispositif de déconnexion de charge (13) encore en train de découpler le circuit de charge (3) des bornes de la charge (32a, 32b), la différence des mesures de tension étant représentative de l'impédance entre les bornes de source (31a, 31b) et d'un taux de décharge correspondant de la capacité (C_{load}, 4) entre les bornes de source (31a, 31b) ,
• pour déterminer si la différence entre les mesures de tension se situe en dehors des limites haute et basse prédéterminées, une différence entre les mesures de tension en dehors des limites haute et basse prédéterminées indiquant la présence d'un corps étranger ou d'un individu entrant en contact avec les bornes de la source ou de la charge (32a, 32b) ou une défaillance du matériel du système de distribution de puissance, et
• pour ne fermer le dispositif de déconnexion de source (7) et le dispositif de déconnexion de charge (13) que si le dispositif de déconnexion de charge peut être commandé, si la différence des mesures de tension se situe dans les limites haute et basse prédéterminées.

2. Système de distribution de puissance selon la revendication 1, comprenant en outre un dispositif de commande de charge (9) du côté de la charge du système de distribution de puissance réagissant à un capteur de charge (8) qui fournit une rétroaction au dispositif de commande de charge (9) qui comprend au moins un signal indiquant la tension aux bornes de la charge (32a, 32b).

3. Système de distribution de puissance selon la revendication 2, comprenant en outre une liaison de communication de données (11) configurée pour l'échange d'informations de fonctionnement entre le dispositif de commande de source (5) et le dispositif de commande de charge (9), les informations de fonctionnement comprenant au moins une valeur indiquant la tension entre les bornes de charge (32a, 32b) qui est acquise par le dispositif de commande de charge (9).

4. Système de distribution de puissance selon la revendication 3, la liaison de communication de données (11) comprenant des circuits de communication sans fil fonctionnant à des fréquences porteuses dans le spectre électromagnétique autorisé par les régulateurs fédéraux.

5. Système de distribution de puissance selon la revendication 3, le dispositif de commande de source (5) et le dispositif de commande de charge (9) comprenant des modems, la communication de données étant réalisée par les modems dans les dispositifs de commande de source et de charge (5, 9) qui peuvent fonctionner pour combiner un signal de communication avec les formes d'onde de tension présentes sur les terminaux de source ou de charge (31a/32a, 31b/32b), et pour séparer ultérieurement le signal de communication des formes d'onde de tension présentes sur les bornes de source ou de charge (31a/32a, 31b/32b), de telle sorte que les dispositifs de commande de source et de charge (5, 9) peuvent communiquer entre eux en utilisant uniquement les connexions entre les bornes de source et de charge (31a, 32a, 31b, 32b).

6. Système de distribution de puissance selon la revendication 5, la communication de données étant réalisée uniquement lorsque la source (1) est déconnectée des bornes de source (31a, 31b), les signaux de communication n'étant pas perturbés par le courant électrique circulant des bornes de source (31a, 31b) aux bornes de charge (32a, 32b).

7. Système de distribution de puissance selon la revendication 3, les dispositifs de commande de source et de charge (5, 9) échangeant un code de vérification numérique qui doit correspondre à une valeur prédéterminée avant que le transfert d'énergie ne puisse être initié.

8. Système de distribution de puissance selon la revendication 2, le dispositif de commande de source (5) étant configuré pour calculer la différence entre la tension aux bornes de la source acquise par le dispositif de commande de source (5) et la tension aux bornes de la charge acquise par le dispositif de commande de charge (9), et pour émettre une commande afin d'ouvrir le dispositif de déconnexion de source (7) si la différence ne se situe pas entre des valeurs haute et basse prédéterminées.

9. Système de distribution de puissance selon la revendication 1, le dispositif de déconnexion de source (7) réagissant à un signal de commande provenant du dispositif de commande de source (5) pour faire varier le rapport du temps pendant lequel la source (1) est connectée aux bornes de la source (31a, 31b) par rapport au temps pendant lequel la source (1) est déconnectée des bornes de la source (31a, 31b) de manière à réguler l'énergie moyenne transférée de la source (1) au circuit de charge (3).

10. Système de distribution de puissance selon la revendication 1, comprenant en outre un capteur de courant (8) qui permet au dispositif de commande de source (5) d'acquérir un signal indiquant le courant électrique circulant de la source (1) aux bornes de la source (31a, 31b), et le dispositif de commande de source (5) étant configuré pour ouvrir le dispositif de déconnexion de source (7) afin de déconnecter la source (1) des bornes de la source (31a, 31b) si le courant électrique dépasse une valeur maximale prédéterminée.

11. Système de distribution de puissance selon la revendication 10, le dispositif de commande de source (5) étant configuré pour multiplier périodiquement les mesures de tension aux bornes de la source par les mesures de courant de la source, ce qui donne une valeur de puissance instantanée calculée, et pour intégrer des valeurs de puissance consécutives afin d'obtenir une valeur d'énergie totale.

12. Système de distribution de puissance selon la revendication 11, le dispositif de commande de source (5) étant également configuré pour appliquer une charge financière à l'utilisateur pour l'énergie extraite de la source.

13. Système de distribution de puissance selon la revendication 1, le dispositif de déconnexion de charge (13) comprenant une diode (39).

14. Procédé de mise en œuvre d'un système de distribution de puissance à courant continu pour le transfert d'énergie d'une source (1) à un circuit de charge (3) via des bornes de source (31a, 31b) et des bornes de charge (32a, 32b) via un courant continu, le système de distribution de puissance à courant continu étant configuré pour détecter des conditions dangereuses qui comprennent des objets étrangers ou des individus conducteurs d'électricité qui sont entrés en contact avec des conducteurs exposés dans le système de distribution de puissance, le procédé comprenant les étapes de :
a) génération d'un signal de réponse dans un dispositif de commande de source (5) pour ouvrir un dispositif de déconnexion de source (7), entraînant l'interruption de la connexion électrique entre la source (1) et les bornes de source (31a, 31b) et un découplage par un dispositif de déconnexion de charge (13) de manière à bloquer au moins le retour du courant électrique du circuit de charge (3) vers les bornes de charge (32a, 32b) auxquelles une capacité (C_{load}, 4) est attachée ;
b) avec le dispositif de déconnexion de source (7) ouvert et avec le circuit de charge découplé électriquement des bornes de charge (32a, 32b), acquisition d'une première mesure de la tension aux bornes de la source (31a, 31b) en utilisant un capteur de tension de bornes de source (34), et stockage de la première mesure de tension pour que le dispositif de commande de source (5) y ait accès ;
c) après l'expiration d'un temps prédéterminé, avec le dispositif de déconnexion de source (7) toujours ouvert et le circuit de charge (3) toujours découplé électriquement des bornes de charge (32a, 32b), acquisition d'une deuxième mesure de la tension aux bornes de la source (31a, 31b) en utilisant le capteur de tension de bornes de source (34) et stockage de la deuxième mesure de tension pour que le dispositif de commande de source (5) y ait accès ;
d) calcul de la différence entre la première mesure de tension stockée et la seconde mesure de tension stockée, la différence représentant le taux de décharge de la capacité entre les bornes de source et de charge (31a, 31b, 32a, 32b) ; et
e) génération de signaux à partir du dispositif de commande de source (5) pour fermer le dispositif de déconnexion de source (7), et le dispositif de déconnexion de charge (13) si le dispositif de déconnexion de charge peut être commandé, si la différence entre la première mesure de tension stockée et la deuxième mesure de tension stockée se situe dans des limites haute et basse prédéterminées, un taux de décharge en dehors des limites haute et basse prédéterminées indiquant qu'il y a un objet étranger ou un individu conducteur qui est venu en contact électrique avec les bornes de source ou de charge (31a/32a, 31b/32b), ou une défaillance du matériel du système de distribution de puissance à courant continu.

15. Procédé selon la revendication 14, le dispositif de commande de source (5) communiquant avec un dispositif de commande de charge (9) en utilisant au moins une liaison parmi une liaison de communication optique, conductrice et sans fil (11).

16. Procédé selon la revendication 15, le dispositif de commande de source (5) faisant l'acquisition d'un code de vérification numérique auprès du dispositif de commande de charge (9) via la liaison de communication (11) et agissant pour que le dispositif de déconnexion de source (7) reste dans un état ouvert si le code de vérification numérique ne correspond pas à un code précédemment stocké dans la mémoire du dispositif de commande de source (5).

17. Procédé selon la revendication 14, le dispositif de commande de source (5) agissant pour faire varier la période de temps de conduction du dispositif de déconnexion de source (7) par rapport à la période de temps de non-conduction du dispositif de déconnexion de source (7) de telle sorte que l'énergie moyenne transférée de la source (1) au circuit de charge (3) peut être régulée selon un algorithme exécuté par le dispositif de commande de source (5).

18. Procédé selon la revendication 14, comprenant en outre :
f) l'exécution d'un code dans le dispositif de commande de source (5) pour acquérir une mesure du courant électrique circulant à travers les bornes de la source (31a, 31b) en utilisant un capteur de courant (8) ;
g) le stockage de la valeur du courant électrique dans la mémoire du dispositif de commande de source ; et
h) l'ouverture du dispositif de déconnexion de source (7) pour déconnecter la source (1) des bornes de la source (31a, 31b) si le courant électrique dépasse une valeur maximale prédéterminée.

19. Procédé selon la revendication 14, comprenant en outre l'exécution d'un algorithme dans le dispositif de commande de source (5) pour calculer la différence entre la tension aux bornes de la source acquise par le dispositif de commande de source (5) en utilisant le capteur de tension de bornes de source (34) et la tension aux bornes de la charge acquise par le dispositif de commande de source (5) à partir d'un dispositif de commande de charge (9), et agissant pour ouvrir le dispositif de déconnexion de source (7) si la différence entre la tension aux bornes de la source et la tension aux bornes de la charge ne se situe pas entre des limites haute et basse prédéterminées.

20. Procédé selon la revendication 14, comprenant en outre, au niveau du dispositif de commande de source (5) :
f) l'acquisition d'une mesure du courant électrique circulant à travers les bornes de source (31a, 31b) en utilisant un capteur de courant (8) ;
g) l'acquisition d'une mesure de la tension aux bornes de la source en utilisant un capteur de tension (34) ;
h) la multiplication périodique des mesures de la tension aux bornes de la source par les mesures du courant de la source pour obtenir une valeur de puissance instantanée ; et
i) l'intégration des valeurs de puissance calculées consécutives par rapport au temps pour obtenir une valeur d'énergie totale.

21. Procédé selon la revendication 20, comprenant en outre l'application d'une charge financière à un utilisateur de l'énergie pour l'énergie extraite par l'utilisateur de la source (1).

22. Procédé selon la revendication 14, le dispositif de commande de source (5) faisant l'acquisition d'une première mesure de la tension aux bornes de la source en utilisant un capteur de tension (34) alors que le dispositif de déconnexion de source (7) est fermé, puis faisant l'acquisition d'une seconde mesure de la tension aux bornes de la source immédiatement après que le dispositif de déconnexion de source (7) a été ouvert, et calculant la différence entre la première et la seconde mesure de tension, et le dispositif de commande de source (5) prenant des mesures pour ouvrir le dispositif de déconnexion de source (7) si la différence de tension se situe en dehors des limites haute ou basse prédéterminées.

23. Procédé selon la revendication 22, le dispositif de commande de source (5) faisant l'acquisition également d'une mesure du courant électrique circulant à travers les bornes de source (31a, 31b) en utilisant le capteur de courant (8) alors que le dispositif de déconnexion de source (7) est fermé, et divisant la différence de tension par la mesure de courant pour obtenir une valeur pour la résistance des conducteurs entre les bornes de source (31a, 31b) et les bornes de charge (32a, 32b), et le dispositif de commande de source (5) prenant des mesures pour ouvrir le dispositif de déconnexion de source (7) si la valeur de résistance se situe en dehors des limites haute et basse prédéterminées.

24. Procédé selon la revendication 14, comprenant en outre la connexion d'un premier conducteur de sortie de circuit de source à un point de prise central sur une bobine secondaire d'un premier transformateur d'isolation (52) et la connexion d'un deuxième conducteur de sortie de circuit de source à un point de prise central sur une bobine secondaire d'un deuxième transformateur d'isolation (54), et un premier conducteur d'entrée de circuit de charge étant connecté à un point de prise central sur une bobine primaire d'un troisième transformateur d'isolation (53) et un deuxième conducteur d'entrée de circuit de charge étant connecté à un point de prise central d'une bobine primaire sur un quatrième transformateur d'isolation (55), de telle sorte que la configuration annule sensiblement tout flux produit dans les quatre transformateurs (52-55) en raison du courant circulant du circuit de source (50) au circuit de charge (51), et les bornes restantes inutilisées des quatre transformateurs (52-55) pouvant être utilisées pour transmettre et recevoir des données qui sont électriquement isolées et indépendantes du courant électrique circulant du circuit de source (50) au circuit de charge (51).

25. Procédé selon la revendication 24, les données étant communiquées en utilisant une technologie Ethernet.

26. Procédé selon la revendication 24, les données étant communiquées en utilisant une technologie de ligne d'abonné numérique.
